Europäisches Patentamt

European Patent Office

Office européen des brevets

(19)

(11) Publication number: **0 435 155 B1**

(12) **EUROPEAN PATENT SPECIFICATION**

(45) Date of publication of patent specification: **01.06.94**  (51) Int. Cl.5: **H05K  7/20**

(21) Application number: **90124800.5**

(22) Date of filing: **19.12.90**

(54) **Radiating fin having improved life and thermal conductivity.**

(30) Priority: **29.12.89 JP 339981/89**

(43) Date of publication of application:
**03.07.91 Bulletin  91/27**

(45) Publication of the grant of the patent:
**01.06.94 Bulletin  94/22**

(84) Designated Contracting States:
**DE FR GB**

(56) References cited:
**EP-A- 0 124 029**    **US-A- 4 115 837**
**US-A- 4 361 720**    **US-A- 4 535 384**
**US-A- 4 621 304**    **US-A- 4 626 960**
**US-A- 4 700 273**    **US-A- 4 788 627**

(73) Proprietor: **SUMITOMO ELECTRIC INDUS-TRIES, LTD.**
**5-33, Kitahama 4-chome,**
**Chuo-ku**
**Osaka-shi, Osaka 541(JP)**

(72) Inventor: **Osada, Mitsuo**
**Itami Works**
**Sumitomo Electric Industries, Ltd.**
**1-1, Koyakita 1-chome, Itami-shi, Hyogo(JP)**
Inventor: **Abe, Yugaku**
**Itami Works**
**Sumitomo Electric Industries, Ltd.**
**1-1, Koyakita 1-chome, Itami-shi, Hyogo(JP)**

(74) Representative: **Herrmann-Trentepohl, Werner, Dipl.-Ing. et al**
**Patentanwälte Herrmann-Trentepohl,**
**Kirschner, Grosse, Bockhorni & Partner**
**Forstenrieder Allee 59**
**D-81476 München (DE)**

**Description**

BACKGROUND OF THE INVENTION

Field of the Invention

The present invention generally relates to a radiating fin and, more specifically, to a light radiating fin having improved thermal conductivity. Description of the Background Art

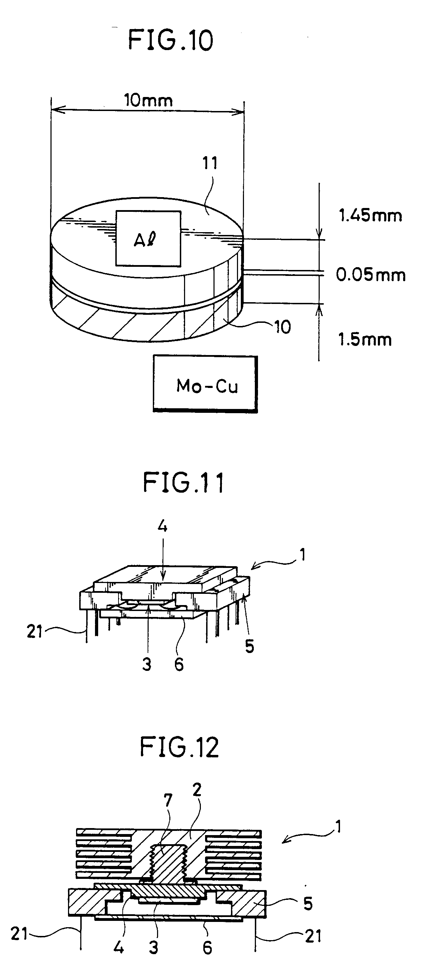

Fig. 11 is a perspective view of a conventional semiconductor packaging device. The semiconductor packaging device 1 comprises a substrate 4 for mounting a semiconductor device 3, and a package 5 having a space for accommodating the semiconductor device 3 and for supporting from downward the substrate 4. The package 5 has a lead 6 therebelow. A lead wire 21 is electrically connected to the semiconductor device 3.

Recently, speed of operation and capacity of ICs have been increased and the ICs have come to be used with higher frequencies, so that heat capacity generated by the semiconductor device 3 is increased. The packaging device shown in Fig. 11 can not sufficiently diffuse the heat externally. Accordingly, there have been various demands for radiating fins for diffusing generated heat to the outside of the semiconductor packaging device 1. This kind of radiating fins must be light and have high thermal conductivity.

Fig. 12 is a cross sectional view of a conventional semiconductor packaging device having a radiating fin. The semiconductor packaging device of Fig. 12 has a radiating fin 2 attached to the semiconductor packaging device of Fig. 11. The substrate 4 is formed of a Mb-W composite material or a Cu-W composite material. The package 5 is formed of alumina. The lead 6 is formed of Kovar (29% Ni-17% Co-Fe). The radiating fin 2 is formed of an aluminum alloy which is light in weight. The radiating fin 2 is attached to the rear surface of the substrate 4 by a screw 7 provided on the rear surface of the substrate 4.

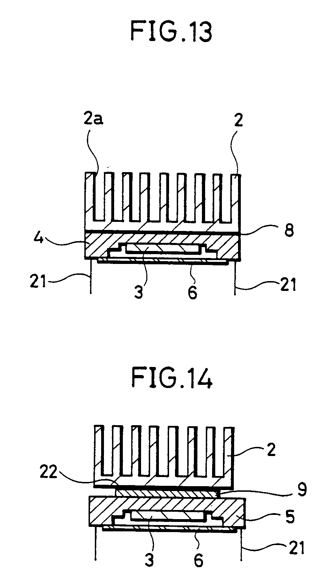

Fig. 13 is a cross sectional view of a conventional compact semiconductor packaging device having a radiating fin. The conventional example shown in Fig. 13 is the same as that of Fig. 12 except the following points, and therefore corresponding portions are denoted by the same reference numerals and the description thereof is not repeated.

In order to make compact, wings 2a of the radiating fin 2 are structured to project upward. The radiating fin 2 is adhered on the substrate 4 by an adhesive 8 including a filler with good thermal conductivity.

The conventional semiconductor packaging device having the radiating fin structured as described above has the following disadvantages. Namely, when the radiating fin 2 is connected to the substrate 4 by means of a screw 7 as shown in Fig. 12, the area of contact between the radiating fin 2 and the substrate 4 cannot be made sufficiently large, so that heat radiation is insufficient. Meanwhile, when the radiating fin 2 and the substrate 4 are connected by an adhesive 8 as shown in Fig. 13, heat radiation is also insufficient since thermal conductivity of the adhesive 8 is inferior. In the semiconductor packaging device shown in Fig. 13, thermal expansion coefficient of the package side (the substrate 4 formed of a Mb-W composite material or a Cu-W composite material and the package 5 formed of alumina) is different from that of the radiating fin 2 (formed of aluminum), peeling occurrs at the connection during heat cycle test (generally in the range of -50°C to 150°C, 300 cycles) after connection, which is a problem in actual use.

In order to solve the above described problem, the inventors of the present invention used Mo-Cu composite materials or W-Cu composite materials separately developed for substrates for loading semiconductor devices (Japanese Patent Publication No. 2-31863) for the radiating fin. The thermal expansion coefficient of the Mo-Cu composite materials or W-Cu composite materials is near that of aluminum or Kovar. Therefore, the above mentioned problem of peeling does not arise during the heat cycle test, when these composite materials are used for the radiating fin. The Mo-Cu composite materials and W-Cu composite materials have superior thermal characteristics as the radiating fin. Especially, the Mo-Cu composite materials having relatively small specific gravity (specific gravity: 9 to 10g/cc) are practically used at present for light radiating fins.

However, even the Mo-Cu composite materials are heavier than aluminum which has been used for the radiating fins (specific gravity: 2.7g/cc), so that they are too heavy when they are applied to a large radiating fin recently demanded for large semiconductor chips.

In order to solve this problem, the Mo-Cu composite material is used at the connecting portion 9 connecting the radiating fin 2 formed of aluminum and the package 5 formed of alumina, and the connecting portion 9 and the radiating fin 2 is connected by a solder 22 (lead-tin, gold-tin alloy, and so on), as shown in Fig. 14.

However, referring to Fig. 14, the aluminum, which is the material of the radiating fin 2 is readily oxidized and normally the surface thereof is covered with a thin oxide film. Therefore wetting of solder is not good, and plating (normally, nickel plating after zincate processing) is necessary on the surface of the aluminum to enable soldering. Further, molybdenum existing at the junction surface of the Mo-Cu composite material constituting the connecting portion 9 makes the wetting of the solder worse. Accordingly, the junction surface of the Mo-Cu composite material must be plated by nickel plating or the like to enable soldering. In addition, when both are connected by soldering, a prescribed number of cavities are generated in the soldering layer, which prevents good thermal conduction. The thermal conductivity of the solder itself is low, and therefore the solder material also prevent good thermal conduction.

Referring to Fig. 14, the coupled body of the fin 2 and the connecting portion 9 provided by the above described method must be plated with nickel, nickel + gold, or the like after soldering, in order to provide corrosion resistance. However, plating of the resulting item including various and many materials was difficult, since various materials react differently against chemicals.

## SUMMARY OF THE INVENTION

An object of the present invention is to provide a radiating fin in which the fin and connecting portion is coupled firmly.

Another object of the present invention is to provide a light radiating fin.

A further object of the present invention is to provide a radiating fin having superior thermal conductivity.

A still further object of the present invention is to provide a radiating fin which is light and has superior thermal conductivity.

A still further object of the present invention is to provide a radiating fin on which plating for providing corrosion resistance is easily done.

A still further object of the present invention is to provide a radiating fin which is firmly coupled with the package.

The present invention is related to a radiating fin mounted on a semiconductor packaging device for accommodating a semiconductor device for externally diffusing heat generated from the semiconductor device. The radiating fin comprises a fin formed of an aluminum alloy, and a connecting portion for connecting the fin to the semiconductor packaging device, formed of a composite material selected from the group consisting of Mo-Cu, Cu-W and Aℓ-Si. The fin and the connecting portion are friction welded at the boundary.

In accordance with a preferred embodiment of the present invention, tip end of the connecting portion has a conical shape going in the fin at the boundary between the fin and the connecting portion.

The radiating fin of the present invention is light, since aluminum alloy is used for the fin. The connecting portion formed of a composite material selected from the group consisting of Mo-Cu, Cu-W and Aℓ-Si and the fin are friction welded at the boundary, so that they are firmly bonded by metallic bond.

Any of Mo-Cu, Cu-W and Aℓ-Si has superior thermal conductivity, and since there is such a member as solder making worse the heat conductivity at the boundary between the fin and the connecting portion, the resulting radiating fin has superior thermal conductivity.

The difference in thermal expansion coefficient of the connected portion formed of the composite material selected from the group consisting of Mo-Cu, Cu-W and Aℓ-Si and that of the material forming the package is small, so that thermal distortion is not generated at the boundary between the package and the connecting portion. Namely, the radiating fin and the package is firmly connected, and the life thereof can be made longer.

The foregoing and other objects, features, aspects and advantages of the present invention will become more apparent from the following detailed description of the present invention when taken in conjunction with the accompanying drawings.

## BRIEF DESCRIPTION OF THE DRAWINGS

Fig. 1 is a perspective view of a radiating fin in accordance with one embodiment of the present invention;

Fig. 2 is a cross sectional view of a semiconductor packaging device having the radiating fin of the present invention;

Fig. 3 is a perspective view (a) and a cross sectional view (b) of the semiconductor packaging device comprising the radiating fin in accordance with another embodiment of the present invention;

Fig. 4 is a schematic view showing steps of manufacturing the radiating fin in accordance with the present invention;

Fig. 5 is a cross sectional view showing steps of manufacturing the radiating fin in accordance with one embodiment of the present invention;

Fig. 6 is a cross sectional view showing steps of manufacturing the radiating fin in accordance with another embodiment of the present invention;

Fig. 7 is a cross sectional view of a junction structure, when angle of a tip end of Mo-Cu composite material is changed, illustrating influence of the shape of junction surface on junction strength;

Fig. 8 shows a structure of a sample for measuring junction strength of the radiating fin in accordance with the present invention;

Fig. 9 is a perspective view of a sample for measuring thermal conductivity of the radiating fin in accordance with the present invention;

Fig. 10 is a perspective view of a sample for measuring thermal conductivity of a conventional radiating fin in which a Mo-Cu composite material and aluminum are connected by soldering;

Fig. 11 is a perspective view of a conventional semiconductor packaging device;

Fig. 12 is a cross sectional view of a conventional semiconductor packaging device comprising a radiating fin;

Fig. 13 is a cross sectional view of another conventional semiconductor packaging device comprising a radiating fin; and

Fig. 14 is a cross sectional view of a further conventional semiconductor packaging device comprising a radiating fin.

## DESCRIPTION OF THE PREFERRED EMBODIMENTS

Embodiments of the present invention will be described in the following with reference to the figures.

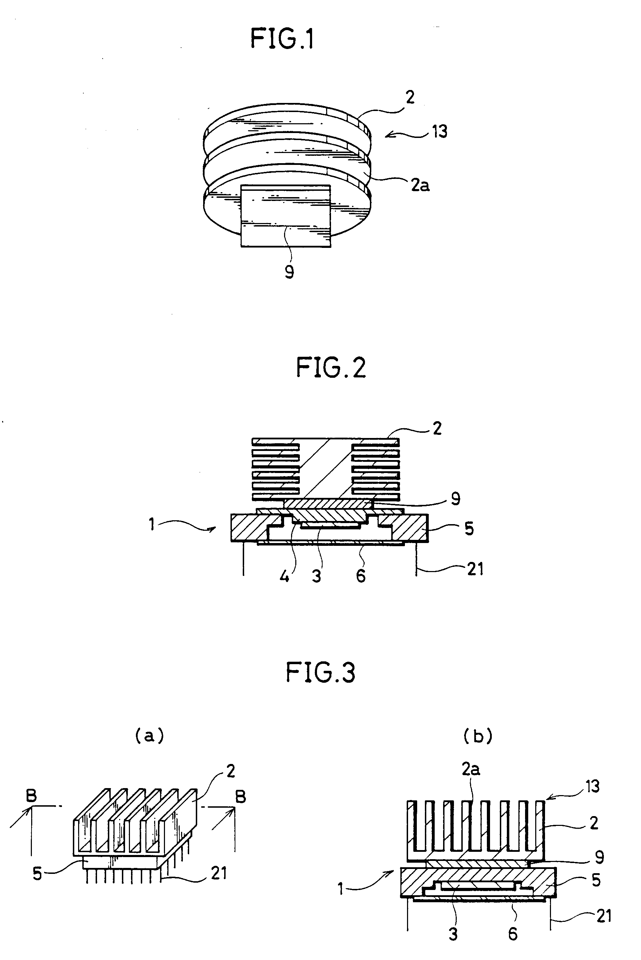

Fig. 1 is a perspective view of a radiating fin in accordance with one embodiment of the present invention. The radiating fin 13 is attached to a substrate for mounting a semiconductor device for externally diffusing heat generated from the semiconductor device. The radiating fin 13 comprises a fin 2 formed of an aluminum alloy and a connecting portion 9. The connecting portion 9 is formed of a composite material formed of Mo-Cu, Cu-W or Aℓ-Si. The fin 2 and the connecting portion 9 are friction welded and in tight contact at the boundary. The fin 2 and the connecting portion 9 friction welded and in tight contact are metal-bonded at the boundary.

Fig. 2 is a cross sectional view of a semiconductor packaging device to which the radiating fin in accordance with the embodiment is attached.

The semiconductor packaging device 1 comprises a substrate 4 for mounting the semiconductor device 3, and a package 5 having a space for accommodating the semiconductor device 3 and for supporting from downward the substrate 4. The package 5 has a lid 6 attached therebelow. A lead wire 21 is electrically coupled to the semiconductor device 3.

The radiating fin 13 having the connecting portion 9 and the fin 2 coupled by metal-bond is fixed to the semiconductor packaging device 1 by attaching the connecting portion 9 to the substrate 4 by a thermal conductive adhesive (epoxy resin + Ag).

The substrate 4 is formed of a Mb-W campsite or a Cu-W composite. The package 5 is formed of alumina. The lid 6 is formed of Kovar (29%Ni - 17%Co - Fe).

Table 1 shows results of measurement of thermal expansion coefficient and thermal conductivity of Cu-W alloy used for the connecting portion 9. Thermal expansion coefficients of $Aℓ_2O_3$, Si, GaAs are also shown in the table.

## Table 1

| No. | Alloy Composition (wt.%) | Thermal Expansion Coefficient (x 10-6/°C) | Thermal Conductivity (cal/cm.sec°C) |
|---|---|---|---|
| 1* | 1Cu-99W | 4.7 | 0.40 |
| 2 | 5Cu-95W | 5.2 | 0.45 |
| 3 | 10Cu-90W | 7.0 | 0.50 |
| 4 | 15Cu-85W | 7.9 | 0.54 |
| 5 | 20Cu-80W | 8.3 | 0.58 |
| 6 | 25Cu-75W | 9.0 | 0.62 |
| 7 | 30Cu-70W | 9.7 | 0.65 |
| 8* | 35Cu-65W | 11.0 | 0.69 |
| 9* | 40Cu-60W | 11.8 | 0.73 |
| 10 | 10Cu-89W-1Ni | 7.0 | 0.48 |
| 11 | 20Cu-79.5W-0.5Ni | 8.2 | 0.57 |
| 12 | 5Cu-80W-15Fe | 7.9 | 0.42 |
| 13 | 10Cu-79W-11Co | 8.1 | 0.46 |
| 14* | $Al_2O_3$ | 7.2 | |
| 15* | Si | 4.0 | |
| 16* | GaAs | 6.7 | |

As is apparent from Table 1, the difference of thermal expansion coefficient between Cu-W alloy and $Al_2O_3$ is made very small when 2 to 30 weight % of Cu is included in the Cu-W alloy.

Table 2 shows results of measurement of thermal expansion coefficient and thermal conductivity of Mo-Cu alloy used for the connecting portion 9 in accordance with another embodiment of the present invention.

Table 2

| No. | Alloy Composition (wt.%) | Thermal Expansion Coefficient $(x\ 10^{-6})°C$ | Thermal Conductivity $(cal/cm.sec°C)$ |
|---|---|---|---|
| 1* | 1Cu-99Mo | 5.3 | 0.35 |
| 2 | 5Cu-95Mo | 5.9 | 0.38 |
| 3 | 10Cu-90Mo | 6.5 | 0.41 |
| 4 | 15Cu-85Mo | 7.1 | 0.44 |
| 5 | 20Cu-80Mo | 7.9 | 0.48 |
| 6 | 25Cu-75Mo | 8.4 | 0.50 |
| 7 | 30Cu-70Mo | 9.1 | 0.54 |
| 8* | 35Cu-65Mo | 9.7 | 0.57 |
| 9* | 40Cu-60Mo | 10.3 | 0.60 |
| 10* | 50Cu-50Mo | 11.5 | 0.66 |
| 11 | 10Cu-89.5Mo-0.5Ni | 6.5 | 0.39 |
| 12 | 15Cu-82.0Mo-3.0Ni | 7.2 | 0.41 |
| 13 | 5Cu-78Mo-17Fe | 8.2 | 0.36 |
| 14 | 10Cu-82Mo-8Co | 7.8 | 0.40 |

Referring to the tables, the Mo-Cu and Cu-W alloys have superior thermal conductivity. In addition, since there is no member such as the solder decreasing thermal conductivity existing at the boundary between the fin 2 and the connecting portions 9, the provided radiating fin 13 has superior thermal conductivity.

Since the difference between the thermal expansion coefficient of the connecting portion 9 formed of Mo-Cu or Cu or Cu-W alloy and that of the material (Cu-W, $Al_2O_3$ or the like) constituting the package 5 is small, thermal distortion is not generated at the boundary between the package 5 and the connecting portion 9. Namely, the radiating fin 13 is firmly connected to the package 5, and the life of the semiconductor packaging device can be made longer.

Fig. 3 is a cross sectional view of a semiconductor packaging device to which the radiating fin in accordance with another embodiment of the present invention is attached.

Fig. 3 (a) is a perspective view of the semiconductor packaging device comprising the radiating fin, and Fig. 3 (b) is a cross sectional view taken along the line B-B of Fig. 3 (a).

Referring to the these figures, the semiconductor packaging device 1 comprises a package 5 (formed of alumina) for accommodating the semiconductor device 3. A lid 6 (formed of Kovar) is provided below the package 5. A lead wire 21 is electrically connected to the semiconductor device 3. The radiating fin 13 comprises a fin 2 (formed of aluminum alloy) having wings 2a extending upward, and a connecting portion 9. The connecting portion 9 is formed of a Mo-Cu, Cu-W or Al-Si alloy. The connecting portion 9 and the fin 2 are friction welded and in tight contact at the boundary. They are metallic-bonded. The radiating fin 13 having the connecting portion 9 and the fin 2 metallic-bonded is fixed to the package 5 by attaching the connecting portion 9 to the package 5 by using a heat conductive adhesive (epoxy resin + Ag). Since the difference between thermal expansion coefficients of the connecting portion 9 and the package 5 is small, thermal distortion is not generated at the boundary between the package 5 and the connecting portion 9.

In this embodiment also, the radiating fin 13 and the package 5 are connected firmly, and the life thereof can be made longer.

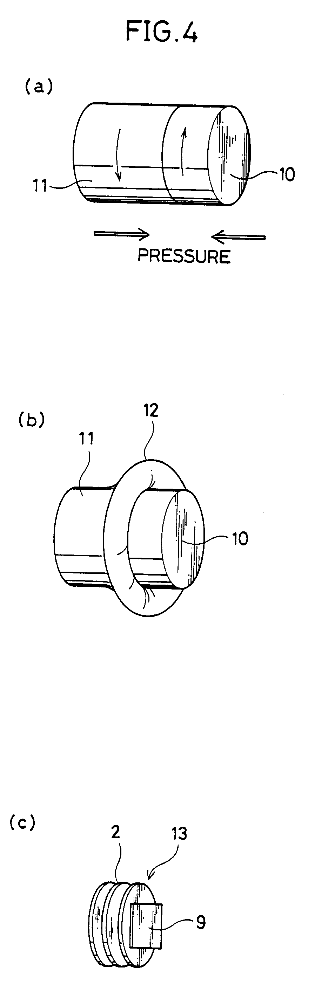

Fig. 4 comprises schematic views showing steps of manufacturing the radiating fin shown in Fig. 1. Referring to Fig. 4 (a), the reference numeral 10 is a Mo-Cu composite material to be the connecting portion (9) of the radiating fin 13 shown in Fig. 1, and the reference numeral 11 represents aluminum to be the fin 2. Junction between the Mo-Cu composite material 10 and the aluminum 11 is carried out by friction welding method, in which junction surfaces of the two are brought into contact and rotated in opposite directions while applying pressure.

In friction welding the aluminum 11 and the Mo-Cu composite 10, appropriate conditions for connection must be set to provide stable junction strength, since characteristics of both materials (rigidity, toughness and so on) are very much different.

When the connection surfaces of the aluminum 11 and the Mo-Cu composite material 10 are brought into contact and they are rotated in opposite directions with pressure applied, then an aluminum oxide film 12 is discharged externally at the connection surface, as shown in Fig. 4 (b). This will be described in detail later, with reference to the figures.

Referring to Fig. 4 (c), a radiating fin 13 having the fin 2 and the connecting portion 9 coupled is provided by cutting the Mo-Cu composite material 10 and the aluminum 11.

By this method, a perfect coupling without cavity at the junction boundary can be provided. In addition, a solid solution layer of copper and aluminum having low thermal conductivity is not generated at the boundary when they are coupled. Consequently, a radiating fin having superior thermal conductivity can be provided. In addition, plating process after connection of the radiating fin 13 formed in this manner is facilitated, since various and many metals such as included in the solder do not exist therein.

In order to provide sufficient junction strength, the oxide film existing on the connecting surface of aluminum must be removed, and therefore the shape of the connecting surface, the number of rotation and the pressure must be set in taking this point in consideration.

Results of friction welding of aluminum and a Mo-Cu composite material under various conditions will be described in the following.

Embodiment 1

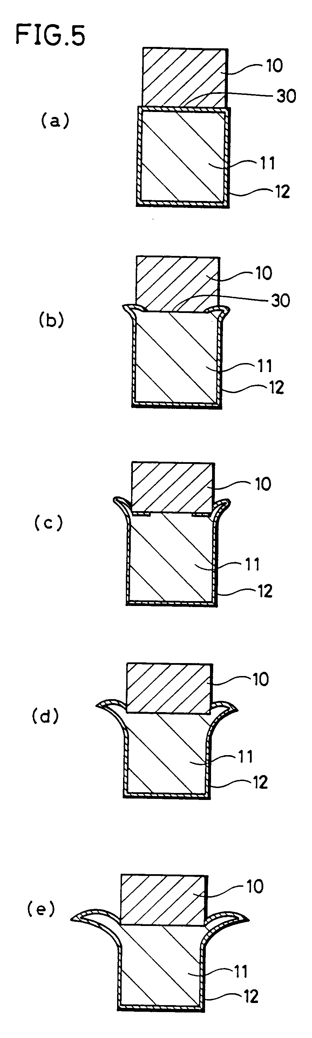

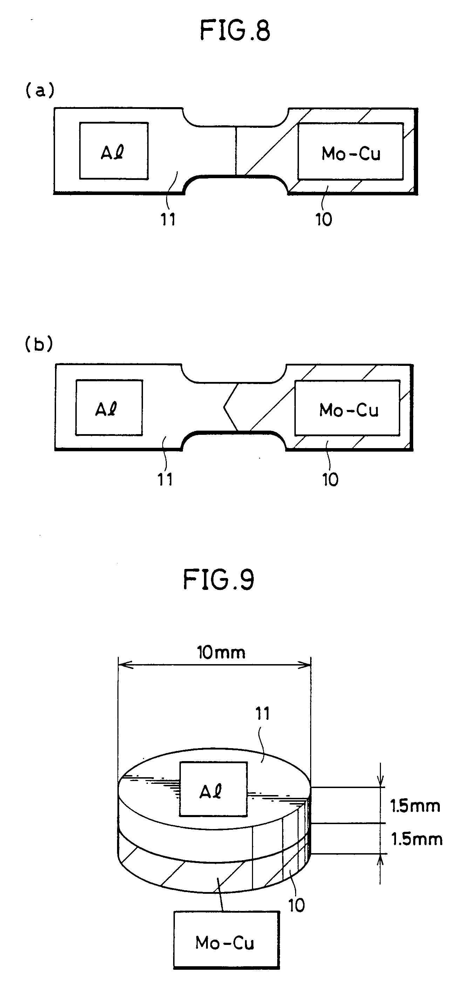

Figs. 5 (a) to (e) show states of friction welding of aluminum and a Mo-Cu composite material when the junction surfaces are flat, showing deformation on time base. In the figures, the reference numeral 10 represent the Mo-Cu composite material, 11 represents aluminum, and 12 represents an aluminum oxide film formed on the surface of aluminum 11. Referring to these figures, when the junction surfaces are flat, deformation during welding occurs on the side of aluminum 11, since toughness of the Mo-Cu composite material 10 is higher than that of aluminum 11. Conditions of friction welding sufficient to externally remove the aluminum oxide film 12 out of the junction surface 30 must be selected. The junction strength ($Kg/mm^2$) at various states were obtained by using a sample having the shape of Fig. 8 (a). The results are shown in Table 3.

Table 3

| Friction time (sec) | 2 | 4 | 6 | 8 |
|---|---|---|---|---|
| Deformation | Fig. 5(b) | Fig. 5(c) | Fig. 5(d) | Fig. 5(e) |
| Junction Strength $(kg/mm^2)$ | 3.5 | 15.3 | 15.4 | 15.3 |

(1) Material: Aluminum (6061 type) 30x 30mm Mo-Cu composite (Mo85% Cu15%) 30 x 30mm
(2) Conditions of friction welding: Number of rotation 1500rpm, pressure 5kg/mm$^2$

Embodiment 2

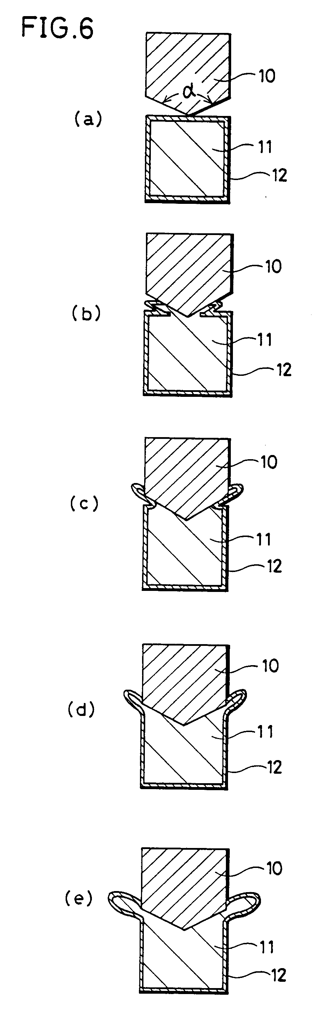

Figs. 6 (a) to (e) show friction welding of the aluminum 11 and the Mo-Cu composite 20 when the angle $\alpha$ of the edge of the Mo-Cu composite material is 120°, showing deformation on time base. The junction strength (Kg/mm$^2$) at respective states were obtained by using a sample having the shape of Fig. 8 (b). The results are shown in Table 4.

Table 4

| Friction time (sec) | 2 | 4 | 6 | 8 |
|---|---|---|---|---|
| Deformation | Fig. 5(b) | Fig. 5(c) | Fig. 5(d) | Fig. 5(e) |
| Junction Strength $kg/mm^2$ | 23.5 | 24.2 | 24.2 | 24.0 |

(1) Material: Aluminum (6061 type) 30 x 30mm Mo-Cu composite (Mo86% Cu15%) 30 x 30mm
(2) Edge angle ($\alpha$): 120°
(3) Conditions of friction welding: Number of rotation 1500 rpm, pressure 5kg/mm$^2$
According to this embodiment, since the edge of the Mo-Cu composite material 10 has convex conical shape, friction welding starts at a small area at the central portion of the edge surface of the aluminum 11, so that removal of the aluminum oxide film 12 from the junction surface is facilitated. Consequently, the formation of the aluminum 11 during friction welding can be suppressed, and the junction strength can be improved.

Embodiment 3

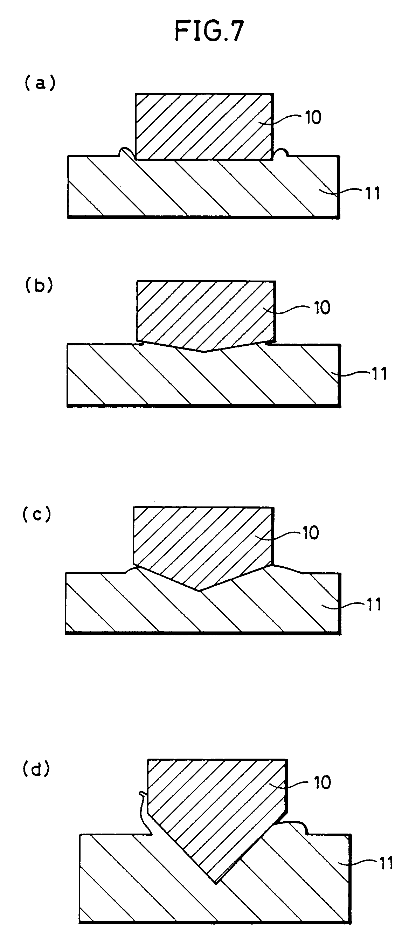

Figs. 7 (a) to (d) are cross sectional views of the junction structure provided when the angle of the edge of the Mo-Cu composite material is 180° (flat), 160°, 120° and 80°, for studying influence of the shape of the junction surface on the junction strength. The results are shown in Table 5.

## Table 5

| Edge angle | | 180° | 160° | 120° | 80° |
|---|---|---|---|---|---|
| Deformation | | Fig. 7(a) | Fig. 7(b) | Fig. 7(c) | Fig. 7(d) |
| Junction | kg/mm$^2$ | 12.7 | 20.7 | 24.6 | 22.5 |
| Strength | deviation | 4.1 | 1.9 | 1.0 | 0.6 |

(1) Material: Aluminum (6061 type) 30 x 30 mm Mo-Cu composite (Mo85% Cu15%) 30 x 30mm
(2) Conditions of Friction Welding: Number of rotation 1500 rpm, pressure 5kg/mm$^2$
(3) Friction time: 6 sec
(4) No. of Samples: 5 each
(5) Junction strength (kg/mm$^2$): mean value of 5 samples
(6) Deviation: difference between Min and Max values.

As is apparent from Table 5, by providing an angle at the edge of the Mo-Cu composite material, the junction strength can be improved. The junction strength (kg/mm$^2$) as high as 10kg is sufficient for actual use.

Embodiment 4

Thermal conductivity of the connected body provided by friction welding of the Mo-Cu composite material 10 and the aluminum 11 shown in Fig. 9 and thermal conductivity of the connected body provided by connecting the Mo-Cu composite 10 to the aluminum 11 by solder 22 shown in Fig. 10 were compared. 5 samples are fabricated, respectively, and thermal conductivity was measured. Measurement of thermal conductivity was carried out by laser flash method, measured from the side of the Mo-Cu composite material 10. The results are shown in Table 6.

## Table 6

| Fig. 9 | .622 | .605 | .605 | .595 | .606 |
|---|---|---|---|---|---|
| Fig. 10 | .428 | .431 | .465 | .451 | .443 |

(1) Unit: cm$^2$/sec
(2) Material: Aluminum (6061 type) Mo-Cu composite (Mo85% Cu15%)

As is apparent from Table 6, thermal conductivity of the connected body provided by friction welding of the Mo-Cu composite material 10 and the aluminum 11 is considerably larger than the connected body connected by the solder 22.

Although the connecting portion was formed of a Mo-Cu alloy or a Cu-W alloy in the above embodiments, the present invention is not limited to this but an Aℓ-Si alloy may be used to provide the same effect.

Although aluminum was used for the fin in the above described embodiments, the present invention is not limited to this, and an Aℓ alloy having other elements added (for example, Aℓ-Si alloy) may be used. In addition, an iron family element not higher than 20 wt% may be added to provide stronger frame of W or Mo. By adding such element, degree of sintering of W or Mo is also improved.

As described above, the radiating fin in accordance with the present invention is light, since aluminum alloy is used for the fin. Since the connecting portion formed of a composite material selected from the group consisting of Mo-Cu, Cu-W and Aℓ-Si and the fin are friction welded and in tight contact at the boundary, they are firmly connected by metallic bond.

In addition, Mo-Cu, Cu-W and Aℓ-Si have superior thermal conductivity, and there is no such member as solder decreasing thermal conductivity existing at the boundary between the fin and the connecting portion. Therefore, provided radiating fin has superior thermal conductivity.

Since difference between thermal expansion coefficient of the connecting portion formed of a composite material selected from the group consisting of Mo-Cu, Cu-W and Aℓ-Si and that of the material forming the package is small, thermal distortion is not generated at the boundary between the package and the connecting portion. Therefore, the radiating fin is firmly connected to the package, elongating the life thereof.

## Claims

1.  A radiating fin attached to a semiconductor packaging device for accommodating a semiconductor device (3) for externally diffusing heat generated from said semiconductor device, comprising:
    a fin (2) formed of an aluminum alloy; and
    a connecting portion (9) formed of a composite material selected from the group consisting of Mo-Cu, Cu-W and Aℓ-Si for connecting said fin to said semiconductor packaging device;
    said fin and said connecting portion being friction welded at the boundary therebetween.

2.  A radiating fin according to claim 1, wherein
    content of Cu in said Mo-Cu composite material is 2 to 30 wt. %.

3.  A radiating fin according to claim 1, wherein
    significant gravity of said Mo-Cu composite material is 9 to 10 g/cc.

4.  A radiating fin according to claim 1, wherein
    said Mo-Cu composite material or said Cu-W composite material includes an iron family element.

5.  A radiating fin according to claim 4, wherein
    content of said iron family element is not higher than 20 wt%.

6.  A radiating fin according to claim 1, wherein
    content of Cu in said Cu-W composite material is 2 to 30 wt%.

7.  A radiating fin according to claim 1, wherein
    boundary between said fin and said connecting portion is flat.

8.  A radiating fin according to claim 1, wherein
    at the boundary between said fin and said connecting portion, an edge of said connecting portion is conical shape going in facing said fin.

9.  A radiating fin according to claim 8, wherein
    angle of the edge of said conical shape is not higher than 160°.

10. A radiating fin according to claim 1, wherein
    said Aℓ alloy comprises pure Aℓ.

11. A radiating fin according to claim 1, wherein
    said Aℓ alloy comprises an Aℓ-Si alloy.

## Patentansprüche

1.  Kühlkörper, der an einer Halbleiteraufnahmevorrichtung zum Aufnehmen einer Halbleitereinrichtung (3) zum Abgeben von durch die Halbleitereinrichtung erzeugter Wärme an die Umgebung angebracht ist, umfassend:
    -   eine Rippe (2), die aus einer Aluminiumlegierung hergestellt ist, und

EP 0 435 155 B1

- einen Verbindungsbereich (9), der aus einem aus der aus Mo-Cu, Cu-W und Al-Si bestehenden Gruppe ausgewählten Verbundmaterial gebidet ist, um die Rippe mit der Halbleiterunterbringungsvorrichtung zu verbinden;
- wobei die Rippe und der Verbindungsbereich an der Grenzfläche dazwischen reibungsgeschweißt sind.

2. Kühlkörper nach Anspruch 1, wobei der Cu-Gehalt in dem Mo-Cu-Verbundmaterial 2 bis 30 Gew.-% beträgt.

3. Kühlkörper nach Anspruch 1, wobei die signifikante Schwerkraft des Mo-Cu-Verbundmaterials 9 bis 10 g/cc beträgt.

4. Kühlkörper nach Anspruch 1, wobei das Mo-Cu Verbundmaterial oder das Cu-W-Verbundmaterial ein Element der Eisen-Familie umfaßt.

5. Kühlkörper nach Anspruch 4, wobei der Gehalt des Elements der Eisen-Familie nicht höher als 20 Gew.-% ist.

6. Kühlkörper nach Anspruch 1, wobei der Gehalt an Kupfer in dem Cu-W-Verbundmaterial 2 bis 30 Gew.-% beträgt.

7. Kühlkörper nach Anspruch 1, wobei eine Grenzfläche zwischen der Rippe und dem Verbindungsbereich flach ist.

8. Kühlkörper nach Anspruch 1, wobei eine Kante des Verbindungsbereichs an der Grenzfläche zwischen der Rippe und dem Verbindungsbereich eine in die Rippe hineinverlaufende konische Form hat.

9. Kühlkörper nach Anspruch 8, wobei der Winkel der Kante der konischen Form nicht mehr als 160° beträgt.

10. Kühlkörper nach Anspruch 1, wobei die Al-Legierung reines AL umfaßt.

11. Kühlkörper nach Anspruch 1, wobei die Al-Legierung eine Al-Si-Legierung umfaßt.

**Revendications**

1. Dissipateur de chaleur fixé à un dispositif d'encapsulation de semi-conducteur destiné à recevoir un dispositif à semi-conducteur (3), pour dissiper vers l'extérieur la chaleur générée par ledit dispositif à semi-conducteur, comportant:
   un dissipateur (2) formé d'un alliage d'aluminium; et
   une partie de connexion (9) formée d'une matière composite choisie dans le groupe constitué de Mo-Cu, Cu-W et Al-Si, destinée à connecter ledit dissipateur audit dispositif d'encapsulation de semi-conducteur;
   ledit dissipateur et ladite partie de connexion étant soudés par friction à l'interface entre ceux-ci.

2. Dissipateur de chaleur selon la revendication 1, dans lequel le contenu de Cu dans ladite matière composite de Mo-Cu est de 2 à 30% en poids.

3. Dissipateur de chaleur selon la revendication 1, dans lequel le poids spécifique de ladite matière composite au Mo-Cu est de 9 à 10 g/cc.

4. Dissipateur de chaleur selon la revendication 1, dans lequel ladite matière composite de Mo-Cu ou ladite matière composite de Cu-W comporte un élément de la famille du fer.

5. Dissipateur de chaleur selon la revendication 4, dans lequel le contenu dudit élément de la famille du fer n'est pas supérieur à 20% en poids.

**6.** Dissipateur de chaleur selon la revendication 1, dans lequel le contenu de Cu dans ladite matière composite de Cu-W est de 2 à 30% en poids.

**7.** Dissipateur de chaleur selon la revendication 1, dans lequel l'interface entre ledit dissipateur et ladite partie de connexion est plate.

**8.** Dissipateur de chaleur selon la revendication 1, dans lequel, à l'interface entre ledit dissipateur et ladite partie de connexion, un bord de ladite partie de connexion est de forme conique contre ledit dissipateur.

**9.** Dissipateur de chaleur selon la revendication 8, dans lequel l'angle du bord de ladite forme conique n'est pas supérieur à 160°.

**10.** Dissipateur de chaleur selon la revendication 1, dans lequel ledit alliage d'Al comporte de l'Al pur.

**11.** Dissipateur de chaleur selon la revendication 1, dans lequel ledit alliage d'Al comporte un alliage d'Al-Si.

# FIG.1

# FIG.2

# FIG.3

(a)          (b)

# FIG.4

(a)

PRESSURE

(b)

(c)

# FIG.5

(a)

(b)

(c)

(d)

(e)

FIG.6

(a)

(b)

(c)

(d)

(e)

# FIG.7

(a)

(b)

(c)

(d)

# FIG.8

(a)

(b)

# FIG.9

# FIG.10

10mm

11

Aℓ

1.45mm

0.05mm

10

1.5mm

Mo-Cu

# FIG.11

4

1

21

3  6

5

# FIG.12

7  2

1

21

4  3  6

5

21

# FIG.13

# FIG.14